Europäisches Patentamt

European Patent Office

Office européen des brevets

(11) Numéro de publication : **0 313 430 B1**

(12)                    FASCICULE DE BREVET EUROPEEN

(45) Date de publication du fascicule du brevet :
14.08.91 Bulletin 91/33

(51) Int. Cl.⁵ : **G11C 29/00, G01R 31/28**

(21) Numéro de dépôt : **88402521.4**

(22) Date de dépôt : **05.10.88**

(54) Dispositif de test structurel d'un circuit intégré.

(30) Priorité : **19.10.87 FR 8714344**

(43) Date de publication de la demande :
**26.04.89 Bulletin 89/17**

(45) Mention de la délivrance du brevet :
**14.08.91 Bulletin 91/33**

(84) Etats contractants désignés :
**DE ES GB IT NL**

(56) Documents cités :
**EP-A- 0 104 442**

(56) Documents cités :
**INTEGRATION TO VLSI JOURNAL, vol. 2, no. 4, décembre 1984, pages 309-330. Amsterdam, NL; K.K. SALUJA et al.: "Testable design of large random access memories"**
**ELECTRO AND MINI/MICRO 23-25 avril 1985, pages 1-4, New York, US; S. GROSSMAN "Testing today's eeproms"**

(73) Titulaire : **SGS-THOMSON MICROELECTRONICS S.A.**
**7, Avenue Galliéni**
**F-94250 Gentilly (FR)**

(72) Inventeur : **Kowalski, Jacek**
**Cabinet Ballot-Schmit 84, Avenue Kléber**
**F-75116 Paris (FR)**

(74) Mandataire : **Ballot, Paul Denis Jacques et al**
**Cabinet Ballot-Schmit 7, rue le Sueur**
**F-75116 Paris (FR)**

## Description

La présente invention a pour objet un dispositif de test structurel d'un circuit intégré. Un tel dispositif est, par exemple, connu de EP-A-0104402, et indiqué dans le préambule de la revendication 1.

L'invention trouve son application dans le domaine des semiconducteurs et plus particulièrement dans le domaine des cartes à mémoire, dites cartes à puce, munies de circuits intégrés électroniques pour assurer diverses fonctions, par exemple d'identification, de clef électronique, ou de mémorisation d'informations ou de soldes de comptes. Elle a pour objet de perfectionner la conception de ces circuits en vue de permettre une augmentation de la densité des fonctions électroniques intégrées dans un même circuit.

Les progrès dans l'évolution de la technologie des circuits intégrés permettent de concevoir des circuits de plus en plus complexes et de moins en moins chers. Ces deux facteurs font augmenter relativement le coût des tests dans le coût global des circuits fabriqués. Il arrive donc un moment où on a intérêt à ajouter des circuits internes de test. Les circuits de test permettent de diminuer le temps de test et donc en conséquence le coût global du circuit intégré total. L'adjonction de tels circuits internes de test conduit néanmoins à l'augmentation de la surface du circuit total. Il faut en conséquence que la surface ainsi consacrée à ces circuits de test soit relativement faible afin que la diminution du coût de test ne soit pas effacée par l'augmentation du prix de fabrication du circuit. En effet, le coût de fabrication du circuit est essentiellement lié à la taille de ce circuit : plus ce circuit est grand moins on peut en fabriquer en même temps ou plus les machines utilisées pour la fabrication doivent être perfectionnées et donc être chères.

Le coût du test est lié principalement au temps de test. Afin de diminuer ce temps de test, des tests structurels sont exécutés. Les tests structurels ne correspondent pas à une vérification de la fonctionnalité globale d'un circuit intégré, mais ils correspondent plutôt à la vérification de la fonctionnalité de blocs logiques internes, chaque bloc logique étant testé séparément.

Un bloc logique se définit comme un circuit possédant des entrées et des sorties. En réponse à des signaux appliqués sur ses entrées il doit délivrer en sortie des signaux attendus. Le test structurel consiste donc à introduire de tels signaux en entrée et à vérifier l'allure des signaux délivrés en sortie. Or, les blocs logiques ne sont pas nécessairement organisés pour aboutir par leurs entrées et/ou par leurs sorties à des bornes de connexion du circuit intégré total. En effet, dans le fonctionnement normal de ce circuit intégré total, les signaux délivrés par ces blocs logiques, activés alors par des signaux de gestion du circuit intégré, n'ont dans la plupart des cas pas besoin d'être extraits. Aussi, si un test structurel permet de diminuer considérablement le temps de test et d'assurer également une vérification exhaustive des comportements du circuit dans tous les cas de figure, il nécessite cependant une lecture externe de toutes les sorties de tous les blocs logiques à tester. Ceci peut conduire à une perte importante de place et à une complication correspondante du circuit intégré total. En définitive, ce qui est gagné en vitesse de test peut être contre-balancé par une perte de place et donc une moins grande capacité du circuit fabriqué.

En pratique on peut résoudre partiellement cette difficulté en utilisant, par exemple pour les connexions de sortie, un registre à décalage qui permet d'enregistrer en série des signaux délivrés par les sorties parallèles d'un bloc logique à tester. On réduit donc dans le rapport de cette transformation parallèle série le nombre des connexions à réaliser dans le circuit. Cependant le registre à décalage lui-même occupe beaucoup de place surtout si le nombre de bits, le nombre des signaux impulsionnels, est important.

Dans l'invention, on remédie à ces inconvénients en remarquant que parmi les circuits intégrés électroniques à tester, certains comportent des mémoires. Pour accéder aux cellules mémoire de ces mémoires, ces circuits comportent alors des décodeurs. L'idée de l'invention repose sur l'utilisation de ces décodeurs déjà existants pour piloter la distribution des signaux d'entrée et/ou de sortie des blocs logiques à tester. Dans l'invention on interpose simplement, entre la mémoire et ces décodeurs, des circuits porte, en cascade avec les blocs logiques, et pilotés par des sorties du décodeur. En organisant un décodage particulier d'adresse on peut valider le fonctionnement de ces circuits porte de telle façon que toutes les fonctions d'un bloc logique soient testées successivement, ou au moins que les signaux résultant de l'exécution des fonctions de ce bloc logique soient pris en compte successivement. Dans un perfectionnement on utilise même le circuit de sortie de la mémoire comme organe de transmission des signaux de test en interposant en série avec le circuit de sortie de la mémoire, un circuit de neutralisation des fonctions normales de cette mémoire et un circuit d'activation de la transmission des signaux résultant de l'exécution des fonctions logiques.

L'invention a donc pour objet un dispositif de test structurel d'un circuit intégré comportant
— des blocs logiques assurant des fonctions logiques,
— des moyens pour introduire des séquences de signaux logiques de test dans ces blocs logiques,
— des moyens pour délivrer des signaux logiques résultant du passage des signaux de test dans ces blocs,
— une mémoire, et un décodeur d'accès à des cellules mémoire de cette mémoire,

caractérisé en ce que

— les moyens pour introduire et/ou pour délivrer comportent un circuit-porte en cascade, respectivement en amont et/ou en aval, avec les blocs logiques,

— ces moyens pour introduire et/ou pour délivrer étant pilotés par le décodeur de la mémoire.

L'invention sera mieux comprise à la lecture de la description qui suit et à l'examen des figures qui l'accompagnent. Celles-ci ne sont données qu'à titre indicatif et nullement limitatif de l'invention. Les figures montrent :

— figure 1 : un dispositif de test structurel conforme à l'invention ;

— figures 2a à 2j : des diagrammes temporels de signaux utilisés pour mettre en oeuvre le dispositif de l'invention.

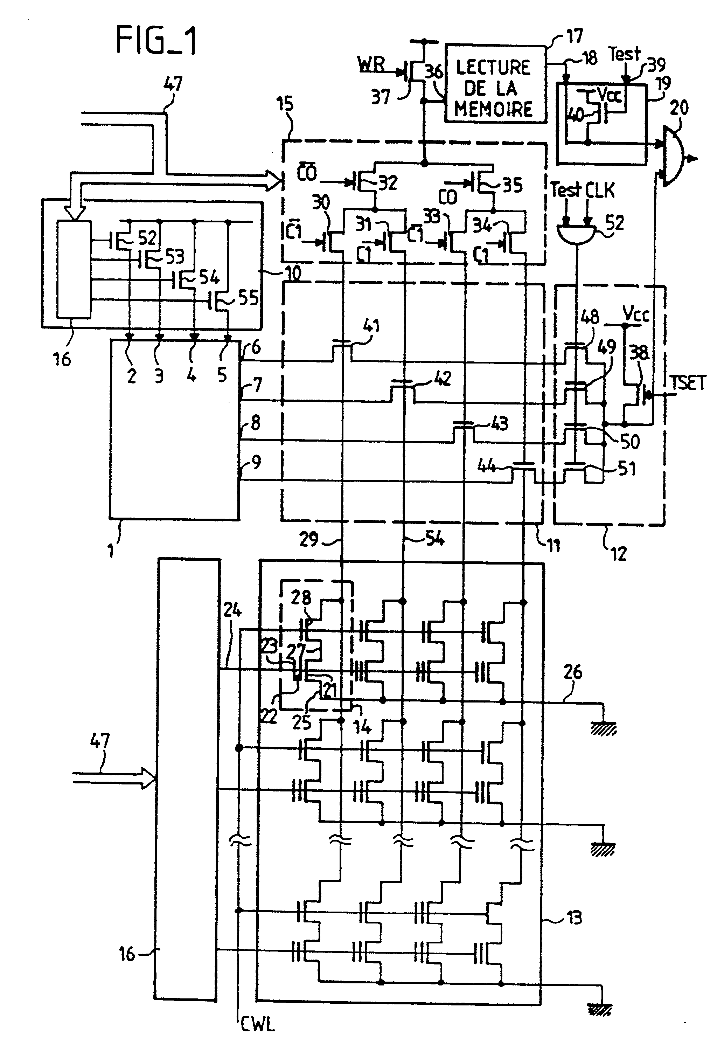

La figure 1 représente un dispositif de test structurel d'un circuit intégré conforme à l'invention. Ce circuit intégré comporte essentiellement des blocs logiques tels que 1, munis d'entrées 2 à 5, et de sorties 6 à 9. Il comporte un circuit 10 pour introduire des séquences de signaux logiques de test dans ces blocs logiques. Il comporte des moyens 11, 12 pour délivrer des signaux logiques résultant du passage des signaux de test dans les blocs. Il est enfin muni d'une mémoire 13 dont on peut accéder aux cellules mémoires telles que 14 par un décodeur d'accès. Pour simplifier, le décodeur d'accès comporte d'une manière connue un décodeur de ligne de bits 15 et un décodeur de ligne de mot 16. Ces deux décodeurs reçoivent des signaux d'adresses de cellules de la mémoire transmises par un bus 47. Ce qui caractérise l'invention est que les moyens pour introduire et/ou pour délivrer, ici les moyens pour délivrer, comportent un circuit-porte 11 en cascade, en aval, avec le bloc logique 1. Ce circuit-porte est piloté par le décodeur de la mémoire : en pratique ici le décodeur de ligne de bits 15.

Dans un perfectionnement de l'invention les circuits de la mémoire comportent un circuit 17 de lecture du contenu des cellules mémoire de la mémoire. Ce circuit de lecture 17 possède une sortie 18 qui assure la transmission des informations lues. Le perfectionnement consiste à interposer dans la connexion de sortie 18 un circuit 19 de neutralisation de la transmission des signaux d'informations lues. Ce circuit de neutralisation fonctionne d'une manière complémentaire avec un circuit 12 d'activation de la transmission des signaux de test. Une porte ET 20 permet de collecter ces signaux d'informations lues et de test, et, selon le mode d'exploitation en vigueur du circuit intégré (normal ou test), de transmettre les deux signaux produits.

Dans une application particulière de type cartes à mémoire, la mémoire 13 comportera des cellules mémoire 14 de type EEPROM comportant essentiellement un transistor 21 à grille flottante 22, dont la grille de commande 23 est commandée par une sortie 24 du décodeur 16 de ligne de mot, dont la source 25 est reliée à une connexion 26 de masse de réseau et dont le drain 27 est relié à la source d'un transistor de commande 28. La grille de commande de ce transistor de commande 28 est reliée à un circuit délivrant un signal CWL de sélection des lignes de mot. Le drain du transistor de commande 28 est relié à une ligne de bits 29. Chaque cellule mémoire 14 est repérée en définitive par l'intersection des lignes de bits 29 et lignes de mot 24 qui y aboutissent. L'exemple représenté sur la figure 1 est un exemple simple : la mémoire 13 comporte un nombre de lignes de bits limité à 4. Cette simplification vise à mieux faire comprendre l'invention.

Avec seulement 4 lignes de bits le décodeur 15 de lignes de bits n'a à décoder que deux bits d'adresse : les bits CO et C1. Dans ce but ce décodeur 15 peut comporter d'une manière classique un jeu de six transistors 30 à 35 organisés hiérarchiquement et recevant les signaux CO, C1, $\overline{CO}$, et $\overline{C1}$. Par exemple, si CO et C1 sont à zéro, les transistors 32 et 30 sont les seuls à être à la fois en série et conducteurs en même temps. En conséquence dans cet exemple la ligne de bits 29 est reliée seule à un potentiel Vcc de polarisation de la mémoire ainsi qu'à une entrée 36 du circuit 17 de lecture de la mémoire. Le potentiel Vcc de polarisation est appliqué par un circuit de polarisation qui comporte d'une manière classique un transistor de polarisation 37 recevant un signal WR de commande de polarisation.

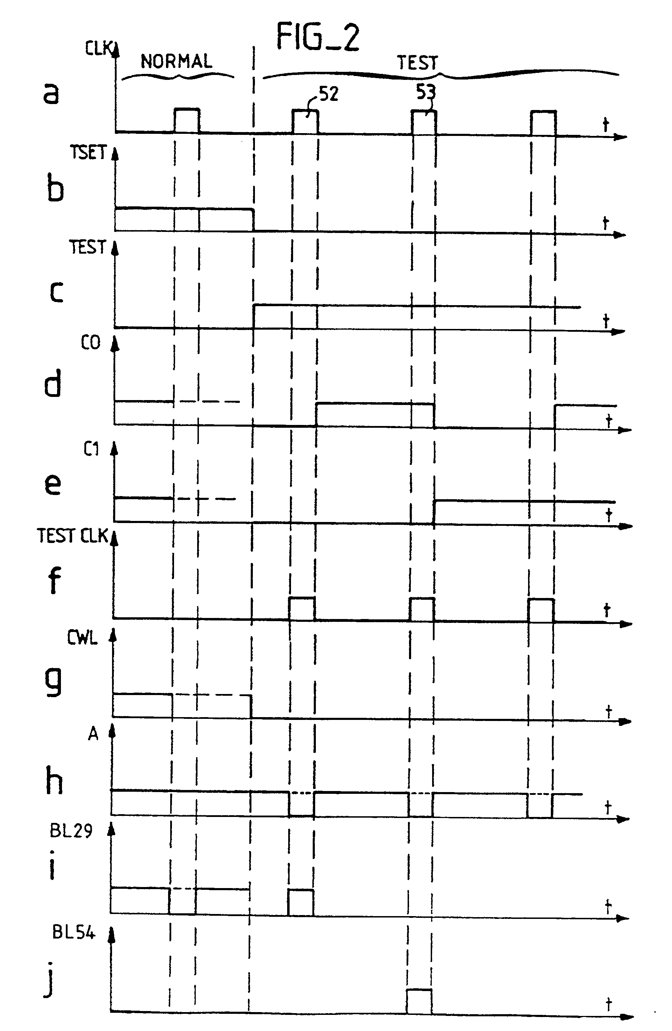

Les figures 2a à 2j montrent des diagrammes temporels du fonctionnement normal du circuit intégré muni de sa mémoire ainsi que la modification de ce fonctionnement résultant des opérations de test. En fonctionnement normal un signal TEST validant le test est à zéro, et son signal complémentaire TSET est porté à un (figures 2c et 2b respectivement). Dans ces conditions le circuit d'activation 12, qui comporte en sortie un transistor 38 commandé par le signal TSET et qui est polarisé par l'alimentation Vcc du circuit intégré total délivre en entrée de la porte ET 20 un signal à un quel que soit l'état des sorties du circuit-porte 11. Le circuit 19 de neutralisation de la lecture est à ce moment désactivé par exemple par la réception du signal TEST sur l'entrée 39 de son transistor 40. Il transmet alors naturellement les signaux détectés par le circuit 17 de lecture de la mémoire en réponse à des signaux d'adresse CO ou C1 transmis par le bus 47 aux décodeurs 15 et 16.

Le fonctionnement normal du circuit de gestion de la mémoire est organisé sous la synchronisation d'une horloge, non représentée, délivrant un signal CLK. Au rythme des signaux de cette horloge les potentiels appliqués sur les lignes de bits sélectionnées (potentiel BL29 sur la ligne de bits 29 par exemple) se maintiennent ou s'écroulent en fonction de l'état de programmation des grilles flottantes 22 des transistors à grille flottante (21) des cellules mémoire (14) sélectionnées. Ce signal de maintien ou d'écroulement est naturellement transmis jusqu'à la sortie de la porte 20. Le circuit 19 de neutralisation comporte un transistor 40 ayant un fonctionnement similaire, quoique piloté par un signal de polarité complémentaire, au fonctionnement du transistor 38 du circuit d'activation 12.

En fonctionnement en mode de test les signaux TEST et TSET sont de polarités inversées par rapport à leur polarité en mode normal. Le circuit-porte 11 comporte essentiellement des portes, matérialisées par des transistors 41 à 44, dont le rôle est d'autoriser, en utilisation en mode de test, la transmission des signaux émanant des sorties 6 à 9 du bloc logique 1 vers l'entrée de la porte 20. Chaque transistor 41 à 44 est relié, par drain et source, en série entre une entrée du circuit 12 d'activation et une sortie correspondante du bloc logique 1. Les grilles de commande des transistors 41 à 44 sont reliées chacune à une des lignes de bits telles que 29 du décodeur 15. Le circuit d'activation 12 comporte en outre une porte OU munie de quatre entrées et comportant quatre autres transistors 48 à 51. Ces autres transistors sont tous reliés d'une part à une borne commune connectée à une entrée de la porte 20 et à la source du transistor 38. Ils sont reliés d'autre part à chacun des transistors 41 à 44 commandant la transmission des signaux disponibles en sortie du bloc logique 1. Les grilles de commande des transistors 48 à 51 sont commandées par une porte ET 52 qui reçoit en entrée le signal de test TEST et le signal d'horloge CLK. La figure 2f indique les périodes, pendant le fonctionnement en mode de test, pendant lesquelles le circuit 12 active effectivement le circuit-porte 11.

De manière à ne pas décharger des lignes de bits qui conduisent à des cellules programmées (et il y a presque toujours des cellules programmées), ou pour ne pas solliciter électriquement les cellules raccordées à cette ligne de bits (ce qui limite la durée de vie de maintien de l'information ou qui peut provoquer des programmations parasites), le signal CWL de commande de sélection de toutes les lignes de mot est porté à zéro pendant les opérations de test (figure 2g). Il en résulte que tous les transistors de commande 28 de chacune des cellules mémoire 14 de la mémoire sont bloqués pendant cette période de test. En conséquence tous les drains 27 des transistors 21 à grille flottante sont en l'air. Aucune immigration de charge ne peut se produire entre ces connexions de drain et les grilles flottantes. La mise à zéro du signal CWL provoque ainsi la neutralisation de la sélection de toutes les cellules mémoire de la mémoire. Donc, non seulement avec le circuit 19 la lecture de la mémoire est neutralisée (ce circuit 19 délivre en sortie un signal qui valide le fonctionnement de la porte ET 20) mais en outre la mémoire 13 est elle-même protégée.

En mode de test, le fonctionnement du dispositif de test structurel est le suivant. Le circuit 10 introduit les signaux d'entrée de test sur les entrées 2 à 5 du bloc logique 1. Les sorties 6 à 9 de ce bloc logique sont alors portées à des niveaux révélateurs de la fonction de se bloc logique. Par le bus d'adresse 47, on sélectionne alors successivement chacune des lignes de bits telles que la ligne de bits 29. En conséquence les transistors 41 à 44 sont fermés chacun à leur tour. Par exemple au début, quand CO et C1 valent zéro, la ligne de bits 29 est portée à un pendant une période correspondant à la durée de l'impulsion d'horloge CLK qui se produit alors que ces signaux CO et C1 sont dans cet état. Pendant cette période le transistor 41 est fermé, il est passant, de même que la porte OU constituée par les quatre transistors 48 à 51. Cette porte OU reçoit par le transistor 48 le signal délivré par la sortie 6 du bloc logique 1. Ce signal est alors naturellement transmis à la porte ET 20.

On peut utiliser les signaux d'horloge pour incrémenter les valeurs des signaux d'adresse. On peut faire en sorte qu'après une première impulsion d'horloge 52, à une impulsion d'horloge suivante 53, le signal CO bascule tandis que le signal C1 se maintient. Dans ces conditions on choisit une ligne de bits suivante, la ligne de bits 54. Le transistor 42 commandé par cette ligne de bits devient alors passant, autorisant la transmission à la porte ET 20 du signal disponible à la sortie 7 du bloc logique 1. Ainsi de suite, la transmission en série des signaux disponibles en parallèle aux sorties du bloc logique 1 s'exécute. On peut éventuellement réitérer l'opération en modifiant les signaux introduits par le circuit 10. On réalise alors une séquence de test qui permet de mieux connaître le fonctionnement du bloc logique 1.

L'invention a été décrite en plaçant le circuit-porte 11 en aval du circuit logique 1 à tester. Il est cependant tout à fait envisageable d'utiliser un autre circuit-porte à la place du circuit 10 d'introduction. Le fonctionnement serait le même. Par un décodage de signaux d'adresse transmis par le bus 47 au décodeur 15 ou au décodeur 16 on pourrait relier les sorties de cet autre circuit-porte aux entrées du bloc logique 1. Eventuellement cette connexion peut aussi se faire par l'intermédiaire d'un autre circuit d'activation ayant le même rôle que le circuit d'activation 12 dans l'exemple décrit. Pour simplifier, cet autre circuit-porte aurait un ensemble de transistors 52 à 55 tous polarisés en commun par l'alimentation générale Vcc du circuit intégré et transmettant en sortie des signaux en fonction des adresses décodées qu'ils recevraient sur leur grille par le décodeur 16 de ligne de mot. Pour assurer le maintien des signaux de sortie du bloc logique 11 jusqu'à l'instant où on effectue la lecture des signaux qu'il délivre, on pourrait interposer en cascade avec ces sorties des bascules de mémorisation. Cependant pour éviter l'interposition de ces bascules on pourrait de préférence utiliser l'autre décodeur, le décodeur 16 de lignes de mot, pour permettre l'introduction des signaux de test, tandis que le décodeur de ligne de bits 15 resterait consacré pendant le même temps à la lecture des signaux testés.

## Revendications

1. Dispositif de test structurel d'un circuit intégré comportant :
— des blocs (1) logiques assurant des fonctions logiques,
— des moyens pour introduire (10) des séquences de signaux logiques de test dans ces blocs logiques,
— des moyens pour délivrer (12, 20) des signaux logiques résultant du passage des signaux de test dans les blocs,
— une mémoire (13), et un décodeur (15, 16) d'accès à des cellules mémoire de cette mémoire,
caractérisé en ce que
— les moyens pour introduire (10) et/ou pour délivrer (12) comportent un circuit-porte (11) en cascade, respectivement en amont et/ou en aval, avec les blocs logiques,
— ces moyens pour introduire et/ou pour délivrer étant pilotés (41, 44) par le décodeur de la mémoire.

2. Dispositif selon la revendication 1 caractérisé en ce que le décodeur comporte un décodeur (15) de ligne de bits relié à un circuit (17) de lecture de la mémoire et un décodeur (16) de ligne de mot, et en ce que le circuit-porte est piloté par le décodeur de ligne de bits.

3. Dispositif selon l'une quelconque des revendications 1 à 2 caractérisé en ce qu'il comporte des moyens (CWL) pour neutraliser la sélection de toutes les cellules mémoire de la mémoire pendant les opérations de test.

4. Dispositif selon l'une quelconque des revendications 1 à 3 caractérisé en ce que les moyens pour délivrer comportent des moyens (12, 19, 20) pour utiliser des circuits de sortie du circuit intégré.

5. Dispositif selon la revendication 4 caractérisé en ce que les moyens pour utiliser comportent des moyens (19) pour neutraliser les fonctions normales du circuit intégré et des moyens (12) pour activer la transmission des signaux résultant de l'exécution des tests.

6. Dispositif selon l'une quelconque des revendications 1 à 5 caractérisé en ce que le décodeur comporte un décodeur (15) de ligne de bits relié à un circuit (17) de lecture de la mémoire et un décodeur (16) de ligne de mot, et en ce que le décodeur (16) de ligne de mot est connecté aux moyens pour introduire par l'intermédiaire d'un autre circuit-porte (52, 55).

## Patentansprüche

1. Vorrichtung zur Strukturprüfung einer integrierten Schaltung, mit
— Logikblöcken (1), die die Logikfunktionen gewährleisten,
— Mitteln zum Eingeben (10) von Folgen von logischen Prüfsignalen in diese Logikblöcke,
— Mitteln zum Ausgeben (12, 20) von Logiksignalen, die aus dem Durchgang der Prüfsignale durch die Blöcke resultieren,
— einem Speicher (13) und einem Dekodierer (15, 16) für den Zugriff auf die Speicherzellen dieses Speichers, dadurch gekennzeichnet, daß
— die Mittel zum Eingeben (10) und/oder zum Ausgeben (12) eine Torschaltung (11) aufweisen, die entsprechend vor und/oder hinter den Logikblöcken mit diesen kaskadenartig angeordnet ist,
— diese Mittel zum Eingeben und/oder zum Ausgeben vom Dekodierer des Speichers gesteuert (41, 44) werden.

2. Vorrichtung gemäß Anspruch 1, dadurch gekennzeichnet, daß der Dekodierer einen Bit-Zeilendekodierer (15), der mit einer Schaltung (17) zum Lesen des Speichers verbunden ist, und einen Wort-Zeilendekodierer (16) aufweist und daß die Torschaltung durch den Bit-Zeilendekodierer gesteuert wird.

3. Vorrichtung gemäß einem der Ansprüche 1 bis 2, dadurch gekennzeichnet, daß sie Mittel (CWL) aufweist, um die Auswahl sämtlicher Speicherzellen des Speichers während der Prüfoperationen aufzuheben.

4. Vorrichtung gemäß einem der Ansprüche 1 bis 3, dadurch gekennzeichnet, daß die Mittel zum Ausgeben (12, 19, 20) Mittel zum Benutzen der Ausgabeschaltungen der integrierten Schaltung aufweisen.

5. Vorrichtung gemäß Anspruch 4, dadurch gekennzeichnet, daß die Mittel zum Benutzen Mittel (19) zum Aufheben der normalen Funktionen der integrierten Schaltung und Mittel (12) zum Aktivieren der Übertragung der aus der Ausführung der Prüfungen resultierenden Signale aufweisen.

6. Vorrichtung gemäß einem der Ansprüche 1 bis 5, dadurch gekennzeichnet, daß der Dekodierer einen Bit-Zeilendekodierer (15), der mit einer Schaltung (17) zum Lesen des Speichers verbunden ist, und einen Wort-Zeilendekodierer aufweist und daß der Wort-Zeilendekodierer (16) über eine dazwischengeschaltete, weitere Torschaltung (52, 55) mit den Mitteln zum Eingeben verbunden ist.

## Claims

1. A device for the structural testing of an integrated circuit, comprising :
— logical blocks (1) for performing logical functions,
— means in order to introduce (10) sequences of logical test signals into the logical blocks,

— means in order to supply (12 and 20) logical signals resulting from the passage of the test signals in the blocks,

— a memory (13) and a decoder (15 and 16) for access to the memory cells of the memory, characterized in that

— the means for the introduction (10) and/or for the supply (12) comprises a series gate circuit (11) connected respectively on the input and/or one the output side of the logical blocks,

— such means for the introduction and/or for the supply being controlled (41 and 44) by the decoder of the memory.

2. The device as claimed in claim 1, characterized in that the decoder comprises a bit line decoder (15) connected with a read circuit (17) for the memory and a word line decoder (16), and in that the gate circuit is controlled by the bit line decoder.

3. The device as claimed in claim 1 or in claim 2, characterized in that it comprises means (CWL) in order to disenable the selection of all the memory cells of the memory during the test operations.

4. The device as claimed in any one of the preceding claims 1 through 3, characterized in that the supplying means comprises means (12, 19 and 20) in order to use the output circuit of the integrated circuit.

5. The device as claimed in claim 4, characterized in that the use means comprises means (19) in order to disenable the normal functions of the integrated circuit and means (12) in order to enable the transmission of the signals resulting from the performance of the tests.

6. The device as claimed in any one of the preceding claims 1 through 5, characterized in that the decoder comprises (15) a bit line decoder (17) connected with a read circuit for the memory and a word line decoder and in that the word line decoder (16) is connected with the introducing means by the intermediary of another gate circuit (52 and 55).

FIG_1

# FIG_2